Europäisches Patentamt

European Patent Office

Office européen des brevets

(19)

(11) Numéro de publication: **0 014 151**
**B1**

(12) **FASCICULE DE BREVET EUROPEEN**

(45) Date de publication du fascicule du brevet: **14.12.83**

(51) Int. Cl.³: **H 03 H 17/02**

(21) Numéro de dépôt: **80400107.1**

(22) Date de dépôt: **23.01.80**

(54) Procédé de traitement des échantillons successifs de signaux et filtre numérique pour la mise en oeuvre du procédé.

(30) Priorité: **29.01.79 FR 7902163**

(43) Date de publication de la demande:
**06.08.80 Bulletin 80/16**

(45) Mention de la délivrance du brevet:
**14.12.83 Bulletin 83/50**

(84) Etats contractants désignés:
**BE DE GB IT SE**

(56) Documents cités:
**FR - A - 2 397 018**

**1978 IEEE INTERNATIONAL CONFERENCE ON ACOUSTICS, SPEECH & SIGNAL PROCESSING (IEEE ICASSP) (Held in Camelot Inn, Tulsa, Oklahoma (US), avril 10-12, 1978) New York US M.G. BELLANGER: "A Multiplexing scheme for multirate Digital Filtering with half band filters" pages 504-507**

**ELECTRO 79 CONFERENCE RECORD, vol. 4, 24-26 avril 1979, section 8/5 "Advances in Digital Signal Processing Hardware and Techniques" New York US R.J. KARWOSKI: "Architecture Development for a general Purpose Digital filter", pages 1-16**

(73) Titulaire: **THOMSON-CSF TELEPHONE**
**146, Boulevard de Valmy**
**F-92707 Colombes (FR)**

(72) Inventeur: **Houdard, Jean-Pierre**
**THOMSON-CSF 46 Quai Alphonse Le Gallo**
**F-92103 Boulogne-Billancourt Cedex (FR)**
Inventeur: **Julie, Jean-Jacques**
**THOMSON-CSF 46 Quai Alphonse Le Gallo**
**F-92103 Boulogne-Billancourt Cedex (FR)**
Inventeur: **Leoni, Bernard, Georges**
**THOMSON-CSF 46 Quai Alphonse Le Gallo**
**F-92103 Boulogne-Billancourt Cedex (FR)**

(74) Mandataire: **Thrierr, Françoise et al,**
**THOMSON-CSF SCPI 173, Bld Haussmann**
**F-75379 Paris Cedex 08 (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Courier Press, Leamington Spa, England.

**0 014 151**

Prodédé de traitement des échantillons successifs de signaux et filtre numérique pour la mise en oeuvre du procédé

La présente invention se rapporte à un procédé de traitement de signaux numériques en vue de leur filtrage ainsi qu'à un filtre numérique transversal, en particulier pour le traitement en temps partagé de signaux numériques de plusieurs canaux, et s'applique avantageusement à des réseaux extrapolateurs.

Lorsque l'on doit filtrer numériquement un signal échantillonné sans l'affecter de distorsion de temps de propagation, on a avantage à utiliser un filtre non récursif à déphasage linéaire. D'autre part, si l'on doit respecter des tolérances serrées pour les caractéristiques d'amplitude et de distorsion de temps de propagation, l'ordre du filtre non récursif doit être élevé (d'au moins 50), et il est difficile d'effectuer un traitement en temps partagé sur un grand nombre de canaux, même au moyen d'opérateurs arithmétiques très rapides. En outre, les filtres numériques connus permettant d'effectuer un traitement en temps partagé sur plusieurs canaux présentent un fort encombrement et sont de prix de revient relativement élevé.

On connaît d'après l'article de M. BELLANGER paru aux pages 504 à 507 du rapport de 1978 IEEE International Conference on acoustics, speech, & signal processing d'Avril 1978, un filtre numérique du type précité, dans lequel le traitement se fait par multiplexage de plusieurs étages d'une seule voie de signal. Un tel multiplexage est fondamentalement différent du multiplexage temporel qui concerne plusieurs voies de signal différentes. Ce filtre numérique connu serait complexe et insuffisamment rapide pour un traitement en temps partagé.

La présente invention a pour objet un procédé de traitement de signaux numériques en vue de leur filtrage, ce procédé permettant d'effectuer le filtrate le plus rapide possible avec les meilleures caractéristiques possibles d'amplitude et de temps de propagation, en particulier dans le cas du traitement en temps partagé sur plusieurs canaux.

La présente invention a également pour objet un filtre numérique pour la mise en oeuvre du procédé de l'invention, ce filtre fonctionnant le plus rapidement possible avec les circuits numériques actuellement disponibles et présentant des caractéristiques d'amplitude et de temps de propagation les meilleures possibles pour un temps de traitement donné très court, ce filtre présentant un encombrement et un prix de revient le plus faibles possibles.

Le procédé conforme à la présente invention, destiné au traitement des échantillons successifs de signaux, en particulier de signaux se présentant sur plusieurs canaux de transmission multiplexés dans le temps, consiste à envoyer à chaque intervalle d'échantillonnage, et pour chaque canal, l'échantillon correspondant dans une mémoire vive en l'inscrivant à la place de l'échantillon le plus ancien, et à lire successivement dans cette mémoire tous les échantillons du même canal, en commençant par celui venant d'être écrit et en progressant dans l'ordre croissant d'ancienneté jusqu'à l'échantillon devenu le plus ancien, en envoyant vers une unité arithmétique les différents échantillons ainsi lus pour les y pondérer de façon appropriée.

Selon un autre aspect du procédé de l'invention, dans le cas où l'on utilise plusieurs mémoires vives, on inscrit dans une première de ces mémoires un échantillon incident à la place de l'échantillon le plus ancien, puis on lit simultanément toutes les mémoires dans l'ordre croissant d'ancienneté en commençant par l'échantillon venant d'être écrit, puis la lecture terminée, on transfère de chaque mémoire vers la mémoire suivante l'échantillon devenu le plus ancien, en commençant par l'avant-dernière mémoire, les mémoires étant disposées dans l'ordre croissant d'ancienneté de leur contenu.

Un filtre numérique transversal d'ordre M conforme à la présente invention, et permettant le traitement de signaux numériques, en particulier le traitement en temps partagé de signaux numériques se présentant sur I canaux de transmission comprend:

— K cellules de traitement, K étant un nombre entier supérieur ou égal à 1, ces K cellules comportant chacune: une mémoire vive organisée selon I pages correspondant chacune à un canal et pouvant stocker chacune au moins P mots de $q$ éléments binaires (bits), avec $M = KP - 1$, cette mémoire étant destinée au stockage des valeurs discrètes retardées; une mémoire morte ayant une capactié de P mots au moins de $r$ éléments binaires chacun pour le stockage des coefficients de pondération des différentes valeurs discrètes retardées; et une unité arithmétique;

— un premier compteur modulo I, commun aux K cellules, pour l'adressage desdites I pages;

— un second compteur modulo P, commun aux K cellules, pour commander les opérations d'écriture, de lecture et de transfert desdites valeurs discrètes retardées;

— un troisième compteur modulo P, commun aux K cellules, pour l'adressage des coefficients de pondération correspondant à l'opération à effectuer.

Selon une variante, le filtre de l'invention comporte également un dispositif additionneur commun aux K cellules pour effectuer la somme des différents résultats partiels produits par chaque unité arithmétique.

La présente invention sera mieux comprise à l'aide de la description détaillée de plusieurs modes de réalisation pris comme exemples non limitatifs et illustrés par le dessin annexé sur lequel:

— la figure 1 est un bloc-diagramme d'un filtre numérique non récursif conforme à la présente invention;

— la figure 2 est le bloc-diagramme d'une variante du filtre de la figure 1;

— la figure 3 est le bloc-diagramme d'un filtre numérique extrapolateur conforme à la présente invention, et

— la figure 4 est le bloc-diagramme d'un filtre numérique récursif comportant deux filtres transversaux selon la figure 2.

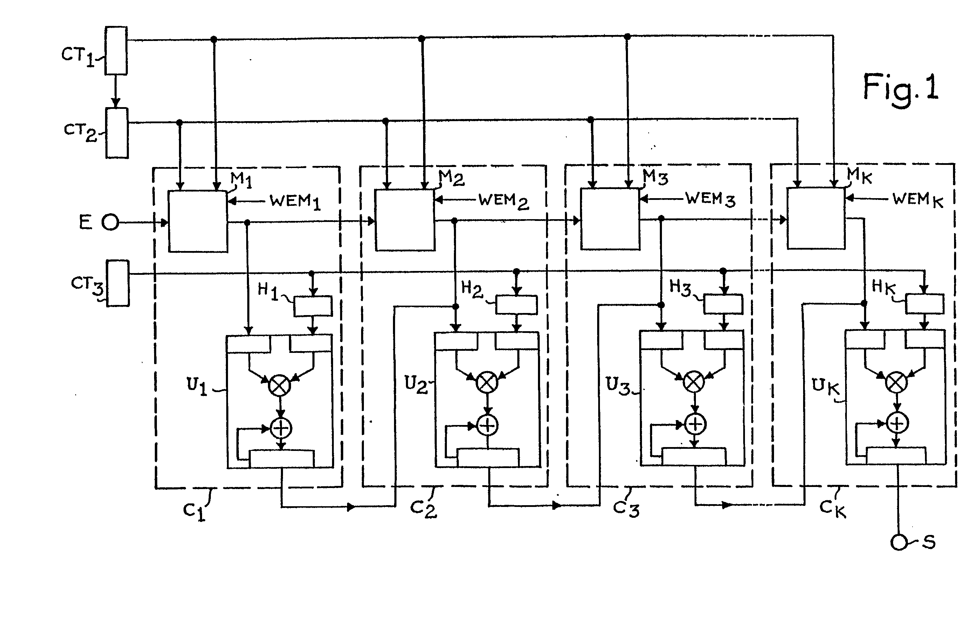

Le filtre numérique non récursif représenté sur la figure 1 est prévu pour traiter en temps partagé des signaux numériques se présentant sur I canaux de transmission, par exemple 32 canaux dans le cas de la téléphonie MIC. Toutefois il est bien entendu que ce filtre peut traiter des signaux se présentant sur un unique canal de transmission.

Le filtre numérique d'ordre M de la figure 1 comporte essentiellement K cellules élémentaires de filtrage à traitement simultané des échantillons, ces cellules étant respectivement référencées $C_1$ à $C_K$, les signaux à traiter arrivant sur une borne E reliée à la première cellule $C_1$ et sortant, après traitement sur une borne S reliée à la dernière cellule $C_K$. Ce filtre comporte également un compteur $CT_1$ modulo I, un compteur $CT_2$ modulo P et un compteur $CT_3$ modulo P, ces trois compteurs étant communs aux K cellules $C_1$ à $C_K$, et leurs rôles seront expliqués ci-dessous.

Chaque cellule élémentaire $C_1$ à $C_K$ comporte une mémoire vive $M_1$ à $M_K$ respectivement, une mémoire morte $H_1$ à $H_K$ respectivement, et une unité arithmétique $U_1$ à $U_K$ respectivement.

Chaque mémoire vive $M_1$ à $M_K$ est une mémoire à écriture parallèle de P.I mots, c'est-à-dire une mémoire comportant I pages correspondant aux I canaux et pouvant contenir chacune au moins P mots de $q$ éléments binaires chacun, ces $q$ éléments binaires étant écrits simultanément dans la mémoire. La sortie de chaque mémoire vive est reliée d'une part à l'entrée de la mémoire vive de la cellule suivante, et d'autre part à l'entrée d'opérande de l'unité arithmétique de sa propre cellule. Ainsi, le filtre numérique est constitué par K cellules élémentaires, chaque cellule contenant P valeurs discrètes retardées avec $M = KP - 1$, étant bien entendu que P ne définit pas l'ordre de chaque cellule. Comme on l'expliquera ci-dessous, les échantillons du signal numérique incident sont stockés dans la première de ces mémoires vives au fur et à mesure de leur arrivée, sont déplacés fictivement à l'intérieur d'une même mémoire, et seul l'échantillon le plus ancien est transféré réellement d'une mémoire vers la suivante. On constitue ainsi une ligne à retard analogue à celle d'un filtre numérique transversal classique, et chaque mot des mémoires vives sera dénommé valeur discrète retardée comme c'est le cas pour un filtre classique.

Chaque unité arithmérique $U_1$ à $U_K$ est un multiplieur-accumulateur à traitement parallèle de constitution connue en soi et de type le plus performant possible, par exemple le circuit intégré TRW, N° TDC 1010J. La sortie de chaque unité arithmétique est reliée à l'entrée d'opérande de l'unité arithmétique de la cellule suivante.

Chaque mémoire morte $H_1$ à $H_K$ a une capacité d'au moins P mots de $r$ éléments binaires, et sert au stockage des coefficients de pondération $h_o$ à $h_{m-1}$ qui restent toujours chacun à la même adresse de la mémoire correspondante. La sortie de chacune de ces mémoires $H_1$ à $H_K$ est reliée à l'entrée d'opérateur de l'unité arithmétique correspondante.

Le compteur $CT_1$ commande l'adressage des I pages des K mémoires $M_1$ à $M_K$, le compteur $CT_2$ commande l'adressage des K mémoires $M_1$ à $M_K$ en vue d'effectuer les opérations d'écriture, de lecture et de transfert des valeurs discrètes retardées, et le compteur $CT_3$ commande l'adressage des K mémoires $H_1$ à $H_K$ pour obtenir les coefficients de pondération correspondant aux valeurs discrètes retardées lues.

On va maintenant expliquer le fonctionnement du filtre numérique de la figure 1 dans le cas simplifié où $K = 4$ et $P = 4$, étant bien entendu que K peut être un entier quelconque depuis $K = 1$, et est théoriquement illimité, et que P peut également avoir une valeur entière quelconque.

T étant la période d'échantillonnage des signaux $x_i$ (nT) sur chacun des I canaux à traiter, le filtre numérique fonctionnant en temps partagé sur I canaux doit donc synthétiser les échantillons de sortie $y_i$ (nT) en un temps inférieur à

$$\frac{T}{I}$$

secondes, la commutation d'un canal au suivant s'effectuant toutes les

$$\frac{T}{I}$$

secondes.

Afin de simplifier les explications, on suppose que le compteur $CT_1$ d'adresse des canaux est à la valeur $i = 0$ et que se présente à l'entrée E du filtre l'échantillon $x_o$ [(n + 1)T]. A la page 0 (correspondant au canal 0) des mémoires $M_1$, $M_2$, $M_3$ et $M_4$ et aux adresses 1, 2 et 3 de ces mémoires se trouvent respectivement, juste avant l'arrivée de $x_o$ [(n + 1)T] les valeurs retardées suivantes, qui ont été inscrites successivement de façon analogue à la façon expliquée ci-dessous:

TABLEAU I

| N° des mémoires / Adresse des mémoires | 0 | 1 | 2 | 3 |
|---|---|---|---|---|
| $M_1$ | $X_0 (nT)$ | $X_0 [(n-1)T]$ | $X_0 [(n-2)T]$ | $X_0 [(n-3)T]$ |
| $M_2$ | $X_0 [(n-4)T]$ | $X_0 [(n-5)T]$ | $X_0 [(n-6)T]$ | $X_0 [(n-3)T]$ |
| $M_3$ | $X_0 [(n-8)T]$ | $X_0 [(n-9)T]$ | $X_0[(n-10)T]$ | $X_0[(n-7)T]$ |
| $M_4$ | $X_0 [(n-12)T]$ | $X_0 [(n-13)T]$ | $X_0 [(n-14)T]$ | $X_0 [(n-11)T]$ |

Remarque: $X_0 [(n-3)T]$ se trouve à la fois dans $M_1$ et dans $M_2$ à l'adresse 3 à cause du transfert de mémoire à mémoire tel qu'expliqué ci-dessous.

Au moment où $X_0 [(n+1)T]$ se présente, les mémoires $M_1$ à $M_4$ sont toutes à l'adresse 3 de la page 0 sous la commande du compteur $CT_2$. Un ordre d'écriture WE $M_1$, émis par un dispositif séquenceur connu en soi et non représenté, vient mémoriser $X_0 [(n+1)T]$ à l'adresse 3 de la page 0 de la mémoire $M_1$, à la place de $X_0 [(n-3)T]$.

La page 0 des mémoires $M_1$ à $M_4$ étant toujours sélectionnée, s'effectue alors la lecture des valeurs discrètes retardées et leur pondération par les coefficients associés $h_0$ à $h_{15}$ en quatre phases à partir de l'adresse 3, simultanément pour les quatre mémoires $M_1$ à $M_4$, le compteur $CT_3$ commandant la lecture des coefficients de pondération $h_0$ à $h_{15}$ pour leur envoi dans les unités arithmétiques respectives.

TABLEAU II

| Phase / Mémoire | 1 | 2 | 3 | 4 |
|---|---|---|---|---|
| $M_1$ | $X_0 [(n+1)T]h_0$ | $X_0 [nT]h_1$ | $X_0 [(n-1)T]h_2$ | $X_0 [(n-2)T]h_3$ |
| $M_2$ | $X_0 [(n-3)T]h_4$ | $X_0 [(n-4)T]h_5$ | $X_0 [(n-5)T]h_6$ | $X_0 [(n-6)T]h_7$ |
| $M_3$ | $X_0 [(n-7)T]h_8$ | $X_0 [(n-8)T]h_9$ | $X_0 [(n-9)T]h_{10}$ | $X_0 [(n-10)T]h_{11}$ |
| $M_4$ | $X_0 [(n-11)T]h_{12}$ | $X_0 [(n-12)T]h_{13}$ | $X_0 [(n-13)T]h_{14}$ | $X_0 [(n-14)T]h_{15}$ |

Après la phase 4 de lecture et de pondération, la page 0 des mémoires $M_1$ à $M_4$ reste sélectionnée, et le compteur $CT_2$ affiche l'adresse 2 à laquelle il est maintenu pendant toute la durée des opérations de transfert entre les mémoires. Ces opérations consistent à effectuer successivement les transferts suivants:

$$X_0 [(n-10)T] \text{ de } M_3 \text{ vers } M_4, X_0 [(n-6)T] \text{ de } M_2 \text{ vers } M_3 \text{ et}$$

$$X_0 [(n-2)T] \text{ de } M_1 \text{ vers } M_2.$$

Pendant ces opérations de transfert les unités arithmétiques $U_1$ à $U_4$ contiennent respectivement (pour le canal 0 bien entendu) les résultats partiels suivants:

pour $U_1$:

$$y_0^1 [(n+1)T] = X_0 [(n+1)T]h_0 + X_0 [nT]h_1 + X_0 [(n-1)T]h_2 + [(n-2)T]h_3$$

pour $U_2$:

$$y_0^2 [(n+1)T] = X_0 [(n-3)T]h_4 + X_0 [(n-4)T]h_5 + X_0 [(n-5)T]h_6 + X_0 [(n-6)T]h_7$$

pour $U_3$:

$$y_0^3 [(n+1)T] = X_0 [(n-7)T]h_8 + X_0 [(n-8)T]h_9 + X_0 [(n-9)T]h_{10} + X_0 [(n-10)T]h_{11}$$

pour $U_4$:

$$y_0^4 [(n+1)T] = X_0 [(n-11)T]h_{12} + X_0 [(n-12)T]h_{13} + X_0 [(n-13)T]h_{14} + X_0 [(n-14)T]h_{15}$$

**0014151**

et les unités arithmétiques $U_2$ à $U_4$ réalisant de proche en proche la somme des résultats partiels, le résultat $y_0^h$ $[(n + 1)T]$ de la cellule N° h étant simplement multiplié par + 1 dans la cellule N° h + 1, et l'on obtient à la sortie S le résultat total:

$$y_0 \; [(n + 1)T] = y_0^1 \; [(n + 1)T] + y_0^2 \; [(n + 1)T] + y_0^3 \; [(n + 1)T] + y_0^4 \; [n + 1)T].$$

$$\frac{T}{1}$$

seconde après l'arrivée de $X_0$ $[(n + 1)T]$, le compteur $CT_1$ s'incrémente d'un pas en passant de l'adresse de voie 0 à l'adresse de voie 1. De même, le compteur $CT_2$, qui était à l'adresse 2 comme précisé ci-dessus, s'incrémente également d'un pas et passe à l'adresse 3, et c'est alors que se présente l'échantillon $X_1$ $[(n + 1)T]$.

A la page 1 des mémoires $M_1$ à $M_4$, correspondant au canal 1, on trouve, juste avant l'arrivée de $X_1$ $[(n + 1)T]$, aux adresses 0, 1, 2 et 3 respectivement les échantillons suivants:

TABLEAU III

| Adresse des mémoires<br><br>N°<br>des mémoires | 0 | 1 | 2 | 3 |
|---|---|---|---|---|
| $M_1$ | $X_1 \; [nT]$ | $X_1 \; [(n{-}1)T]$ | $X_1 \; [(n{-}2)T]$ | $X_1 \; [(n{-}3)T]$ |
| $M_2$ | $X_1 \; [(n{-}4)T]$ | $X_1 \; [(n{-}5)T]$ | $X_1 \; [(n{-}6)T]$ | $X_1 \; [(n{-}3)T]$ |
| $M_3$ | $X_1 \; [(n{-}8)T]$ | $X_1 \; [(n{-}9)T]$ | $X_1 \; [(n{-}10)T]$ | $X_1 \; [(n{-}7)T]$ |
| $M_4$ | $X_1 \; [(n{-}12)T]$ | $X_1 \; [(n{-}13)T]$ | $X_1 \; [(n{-}14)T]$ | $X_1 \; [(n{-}11)T]$ |

Lorsque $X_1$ $[(n + 1)T]$ se présente à l'entrée E, un ordre d'écriture $WEM_1$ fait mémoriser cet échantillon à l'adresse 3 de la page 1 de la mémoire $M_1$.

Ensuite, le traitement s'effectue comme expliqué précédemment pour la page 0, à la différence que c'est à chaque fois la page 1 qui est sélectionnée dans les mémoires $M_2$ à $M_4$ pendant le temps

$$\frac{T}{1}$$

que dure le traitement pour obtenir $y_1$ $[(n + 1)T]$.

Le traitement décrit ci-dessus se répète pour la page 2. Cependant, pour la dernière page, c'est-à-dire la page 3, ce traitement est légèrement différent. En effet, après la phase 4 de lecture et de pondération, la page 3 des mémoires $M_1$ à $M_4$ est toujours sélectionnée et le compteur $CT_2$ affiche l'adresse 2. Le compteur $CT_2$ est maintenu à l'adresse 2 pendant la durée du transfert de $X_3$ $[(n - 10)T]$ de $M_3$ en $M_4$, de $X_3$ $[(n - 6)T]$ de $M_2$ en $M_3$ et de $X_3$ $[(n - 2)T]$ de $M_1$ en $M_2$. Pendant ce temps s'effectue le canal de $y_3$ $[(n + 1)T]$, soit:

$$y_3 \; [(n + 1)T] = y_3^1 \; [(n + 1)T] = y_3^2 \; [(n + 1)T] + y_3^3 \; [(n + 1)T] + y_3^4 \; [(n + 1)T]$$

$$\frac{T}{1}$$

seconde après l'arrivée de $X_3$ $[(n + 1)T]$, l'échantillon $X_0^3$ $[(n + 2)T]$ se présente à l'entrée E, et le compteur $CT_1$ s'incrémente de 1 pas en passant de l'adresse 3 à l'adresse 0; mais le compteur $CT_2$ n'est pas incrémenté et reste donc à l'adresse 2.

On trouve alors à la page 0 des mémoires $M_1$ à $M_4$, juste avant l'arrivée de $X_0$ $[(n + 2)T]$, aux adresses 0, 1, 2, 3 respectivement les valeurs discrètes retardées suivantes:

5

TABLEAU IV

| Adresse des mémoires / N° des mémoires | 0 | 1 | 2 | 3 |
|---|---|---|---|---|
| $M_1$ | $X_0[nT]$ | $X_0[(n-1)T]$ | $X_0[(n-2)T]$ | $X_0[(n+1)T]$ |
| $M_2$ | $X_0[(n-4)T]$ | $X_0[(n-5)T]$ | $X_0[(n-2)T]$ | $X_0[(n-3)T]$ |
| $M_3$ | $X_0[(n-8)T]$ | $X_0[(n-9)T]$ | $X_0[(n-6)T]$ | $X_0[(n-7)T]$ |
| $M_4$ | $X_0[(n-12)T]$ | $X_0[(n-13)T]$ | $X_0[(n-10)T]$ | $X_0[(n-11)T]$ |

Un ordre d'écriture vient ensuite mémoriser $X_0[(n+2)T]$ à l'adresse 2 de la page 0 de la mémoire $M_1$ à la place de $X_0[(n-2)T]$. La page 0 des mémoires $M_1$ à $M_4$ étant donc sélectionnée, on commande la lecture des valeurs discrètes retardées de la page 0 des mémoires $M_1$ à $M_4$ et leur pondération par les coefficients associés en quatre phases, à partir de l'adresse 2 des mémoires, comme suit:

TABLEAU V

| Phase / N° mémoires | 1 | 2 | 3 | 4 |
|---|---|---|---|---|
| $M_1$ | $X_0[(n+2)T]h_0$ | $X_0[(n+1)T]h_1$ | $X_0[nT]h_2$ | $X_0[(n-1)T]h_7$ |
| $M_2$ | $X_0[(n-2)T]h_4$ | $X_0[(n-3)T]h_5$ | $X_0[(n-4)T]h_6$ | $X_0[(n-5)T]h_7$ |
| $M_3$ | $X_0[(n-6)T]h_8$ | $X_0[(n-7)T]h_9$ | $X_0[(n-8)T]h_{10}$ | $X_0[(n-9)T]h_{11}$ |
| $M_4$ | $X_0[(n-10)T]h_{12}$ | $X_0[(n-11)T]h_{13}$ | $X_0[(n-12)T]h_{14}$ | $X_0[(n-13)T]h_{15}$ |

Ensuite, on commande le calcul de $y_0[(n+2)T] = y_0^1[(n+2)T] + y_0^2[(n+2)T] + y_0^3[(n+2)T] + y_0^4[(n+2)T]$ comme décrit ci-dessus à propos de $y_0[(n+1)T]$.

De manière générale, le compteur $CT_1$ s'incrémente d'un pas toutes les

$$\frac{T}{I}$$

secondes, le compteur $CT_3$ est remis à 0 toutes les

$$\frac{T}{I}$$

secondes, et le compteur $CT_2$ est incrémenté d'un pas toutes les

$$\frac{T}{I}$$

secondes sauf lorsque l'on passe de la voie I—1 à la voie 0, cas pour lequel le compteur $CT_2$ ne bouge pas.

Bien entendu, si $K = 1$, il n'y a aucun transfert réel de valeurs discrètes retardées, chaque échantillon incident venant s'incrire à la place de l'échantillon le plus ancien dans la mémoire vive unique.

Il est évident que si les signaux échantillonnés se présentent sur un canal unique, le compteur $CT_1$ est supprimé, et les mémoires $M_1$ à $M_K$ ne comportent chacune qu'une seule page.

**0014151**

Le procédé de traitement de la présente invention est beaucoup plus rapide que le procédé de l'art antérieur, en particulier lorsque l'on doit traiter un grand nombre de valeurs discrètes retardées. En effet, selon l'art antérieur, on utilisait un filtre comportant M cellules de retard en cascade et à chaque intervalle de temps d'échantillonnage T on réalisait, pour I canaux, M.I décalages des valeurs discrètes retardées, M.I. multiplication et M.I additions, c'est-à-dire 3.M.I opérations devant être effectuées en un temps inférieur à T seconde.

Ainsi, dans le cas de la téléphonie, si $T = 62,5 \mu s$, $M = 128$ et $I = 32$, il faudrait réaliser $64.10^6$ opérations en moins d'une seconde, ce qui est irréalisable avec les moyens actuellement connus (les performances des moyens actuels ne permettent de traiter qu'un canal avec un filtre d'ordre 32 et une fréquence d'échantillonnage de 8 kHz.

Par contre, grâce au procédé de la présente invention, on ne décale que K valeurs parmi les $M = KP - 1$ valeurs discrètes retardées de chaque canal, la valeur P pouvant être choisie de façon qu'avec les moyens actuellement disponibles le temps de traitement total pour I canaux, c'est-à-dire le temps de traitement de I fois P valeurs par une unité arithmétique (toutes les unités arithmétiques $U_1$ à $U_K$ travaillant simultanément) et le temps nécessaire à l'addition de I fois K résultats partiels, soit inférieur à la période d'échantillonnage T divisée par le nombre I de canaux. Ainsi, par exemple en téléphonie, pour le traitement de signaux transmis sur 32 canaux avec une fréquence d'échantillonnage de 8 kHz (c'est-à-dire

$$\frac{T}{I} = 3,9 \mu s$$

environ) on peut, avec seulement deux cellules élémentaires, traiter en environ $3,6 \mu s$ plus de 40 valeurs discrètes retardées par canal, le circuit intégré TRW précité permettant d'effectuer en 155 nS maximum la lecture et la pondération d'un mot de 16 bits, le résultat étant disponible à la sortie de l'unité arithmétique en environ 35 nS après la fin du calcul.

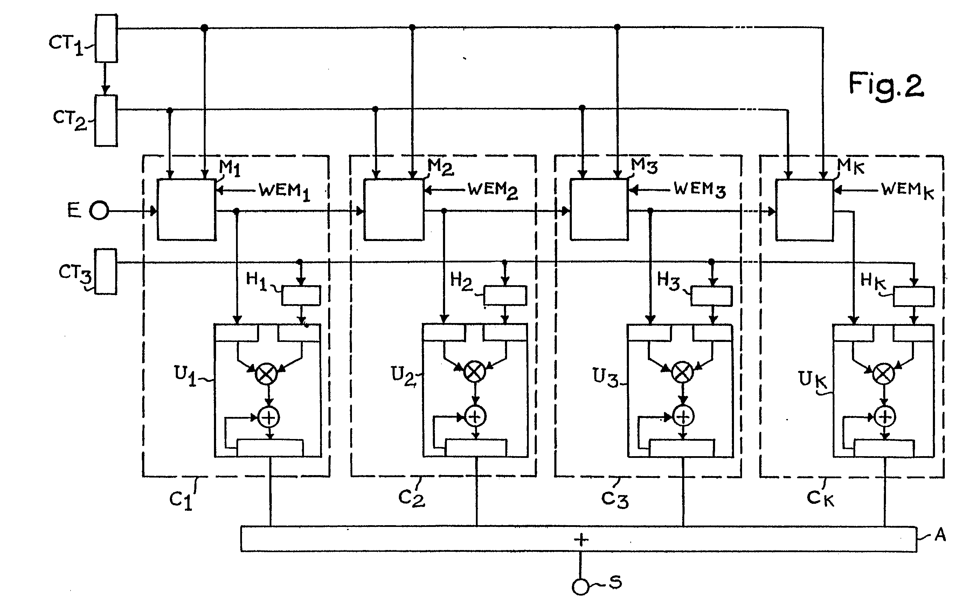

Pour des applications pour lesquelles on doit avoir un filtre d'ordre très élevé, il suffit d'augmenter le nombre de cellules élémentaires, mais dans ce cas, le temps nécessaire à l'addition des différents résultats partiels ces cellules risque d'être trop élevé. Dans ce cas, on utilise le filtre représenté sur la figure 2 sur laquelle les éléments identiques à ceux de la figure 1 sont affectés des mêmes références.

Le filtre de la figure 2 est identique à celui de la figure 1 à la seule différence que les sorties des différentes unités arithmétiques $U_1$ à $U_K$ sont toutes reliées à un additionneur rapide A qui effectue en une seule fois le total de tous les résultats partiels fournis par les K cellules $C_1$ à $C_K$. Cette seule différence mise à part, le filtre de la figure 2 fonctionne de la même façon que le filtre de la figure 1, et c'est pourquoi son fonctionnement ne sera pas expliqué plus en détail.

A titre d'exemple on a pu réaliser grâce au filtre de la figure 1, avec $K = 2$, c'est-à-dire avec seulement deux cellules élémentaires, et avec $P = 30$ soit $M = 59$, le traitement de mots de seize éléments binaires (bits) sur 32 canaux en environ $3,6 \mu s$, les composants nécessaires à la réalisation de ce filtre n'occupant qu'une demi-carte normalisée de circuit imprimé.

On va maintenant décrire l'application du filtre numérique de la présente invention à la réalisation d'un réseau extrapolateur.

Lorsqu'il s'agit de filtrer numériquement un signal échantillonné à la fréquence $F_e$ en vue de ne conserver de ce signal que les composantes spectrales comprises dans l'intervalle $-f_c$, $+f_c$, on sait qu'il suffit de restituer le signal de sortie du filtre avec une fréquence d'échantillonnage $F_e' = 2f_c$. Lorsque $F_e = 4f_c$, il devient intéressant de réaliser la fonction de filtrage par extrapolation en utilisant une cellule de filtrage non récursif demi-bande dont la réponse impulsionnelle est du type

$$\frac{\sin x}{x} .$$

Il en résulte une réduction importante de la vitesse de calcul et une distorsion de phase négligeable. D'autre part, on sait que le signal de sortie d'un réseau extrapolateur est échantillonné à

$$\frac{F_e}{2},$$

ce qui conduirait à calculer tous les échantillons de sortie et à en éliminer un sur deux, mais en pratique il est préférable de calculer les échantillons de sortie à une fréquence égale à

$$\frac{F_e}{2} .$$

7

En outre, on sait que si dans un réseau extrapolateur d'ordre $M' = 2P' - 1$, $P'$ étant pair, l'on rend égal à 1 le coefficient central de réponse impulsionnelle $h_M'$, les autres coefficients deviennent symétriques par rapport à $h_M'$, tous les coefficients $h_m$ de rang impair s'annulent sauf $h_M'$, et le nombre d'opérations arithmétiques à effectuer se réduit presque de moitié.

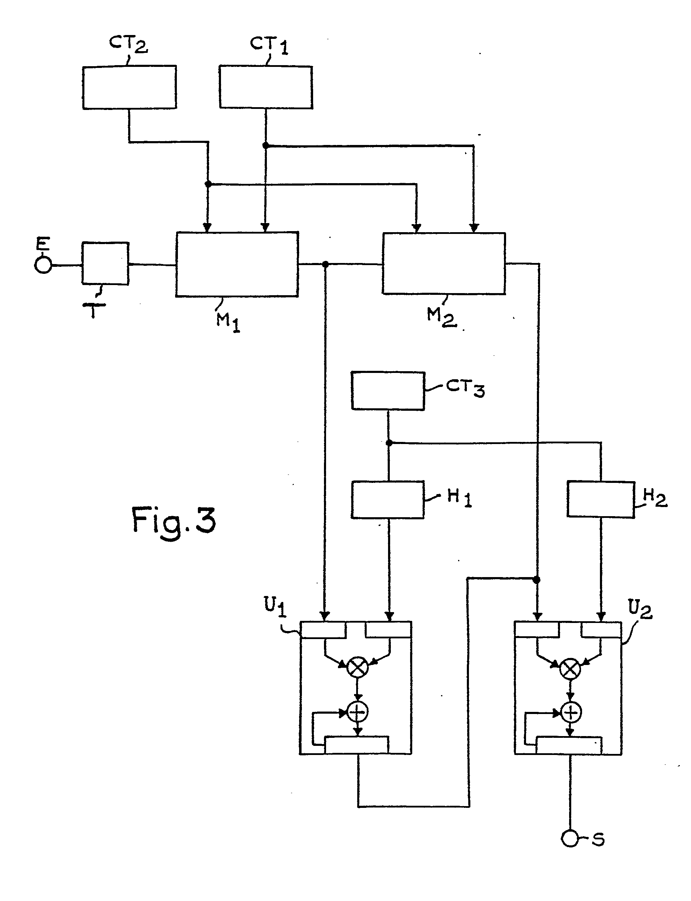

On a représenté sur la figure 3 un réseau extrapolateur d'ordre $N' = 2P' - 1$, constitué d'après les principes exposés ci-dessus, ce réseau étant réalisé à l'aide d'un filtre numérique tel que celui représenté sur la figure 1 et comportant deux cellules élémentaires contenant chacune $P'$ valeurs discrètes retardées, le filtre numérique de la figure 2 pouvant, bien entendu, également convenir.

Etant donné que l'échantillonnage des signaux d'entrée se fait à une fréquence double de celle du calcul, on prévoit à l'entrée du réseau un dispositif tampon T pour stocker deux échantillons. Les autres éléments du réseau de la figure 3 étant identiques à ceux représentés sur la figure 1, on ne les décrira pas plus en détail.

On va maintenant expliquer à l'aide d'un exemple simplifié le fonctionnnement du réseau représenté sur la figure 3.

Pour simplifier les explications, on va examiner un seul canal et prendre un filtre d'ordre peu élevé à deux cellules élémentaires, par exemple un filtre d'ordre $M' = 11$, mais les explications restent valables lorsque l'ordre du filtre est beaucoup plus élevé comme c'est le cas dans la réalité.

L'ordre du filtre étant de 11, il devra comprendre 12 valeurs discrètes retardées, c'est-à-dire, par exemple au moment où X (nT) se présente, les valeurs discrètes retardées X (nT) à X [(n — 8)T], étant entendu que X [(n — 4)T] et X [(n — 5)T] se trouvent à la fois dans $M_1$ et $M_2$. Comme rappelé ci-dessus, les coefficients $h_m$ d'ordre impair, sauf $h_M'$, sont nuls, c'est-à-dire que $h_1$, $h_3$, $h_7$, $h_9$ et $h_{11}$ sont nuls.

A l'instant X (nT) on a dans les mémoires $M_1$ et $M_2$ les valeurs discrètes retardées suivantes:

| Adresse mémoires N° mémoires | 0 | 1 | 2 | 3 | 4 | 5 |
|---|---|---|---|---|---|---|
| $M_1$ | X(nT) | X [(n—1)T] | X [(n—2)T] | X [(n—3)T] | X [(n—4)T] | X [(n—5)T] |
| $M_2$ | X [(n—6)T] | X [(n—7)T] | X [(n—8)T] | X [(n—9)T] | X [(n—4)T] | X [(n—5)T] |

Etant donné que la fréquence de calcul des échantillons de sortie est égale à

$$\frac{F_e}{2} ,$$

l'instant suivant à considérer est X [(n + 2)T]. Les échantillons X [(n + 2)T] et X [(n + 1)T] viennent donc s'inscrire respectivement à la place de X [(n — 4)T] et X [(n — 5)T] dans $M_1$.

La phase de lecture des mémoires $M_1$ et $M_2$ se fait en commençant par les échantillons les plus récents, c'est-à-dire X [(n + 2)T] et X [(n — 4)T] respectivement. L'incrémentation de l'adresse commune aux deux mémoires se fait par pas de deux sauf pour effectuer la dernière incrémentation qui est de un pas puisqu'il ne reste après l'avant-dernière incrémentation qu'une seule valeur discrète retardée à lire dans chaque mémoire. On lit donc successivement:
pour $M_1$:

$$X [(n + 2)T], \ X (nT), \ X [(n — 2)T] \ et \ X [(n — 3)T]$$

pour $M_2$:

$$X [(n — 4)T], \ X [(n — 6)T], \ X [(n — 8)T] \ et \ X [(n — 9)T],$$

et en même temps a lieu la pondération par les coefficients appropriés, c'est-à-dire pour $M_1$: $h_0$, $h_2$, $h_4$ et $h_5$ respectivement, et pour $M_2$: $h_6$, $h_8$, $h_{10}$ et $h_{11}$ respectivement.

Ensuite a lieu l'addition de toutes les valeurs partielles ainsi obtenues puis, les mémoires étant positionnées à l'adresse de la valeur discrète retardée la plus ancienne, c'est-à-dire à l'adresse 3 pour laquelle on trouve X [(n—3)T] dans $M_1$ et X [(n—9)T] dans $M_2$, la valeur contenue dans $M_1$ à l'adresse 3 est transférée dans $M_2$ à la place de la valeur qui était contenue à la même adresse. Puis l'adresse commune à $M_1$ et $M_2$ est décrémentée d'une unité et passe à 2, à laquelle on trouve X [(n — 2)T] dans $M_1$ et X [(n — 8)T] dans $M_2$, et le contenu de $M_1$ à l'adresse 2 est transféré dans $M_2$ à la même adresse. Ce second transfert s'achève juste avant l'arrivée des deux échantillons suivants, c'est-à-dire X [(n+4)T] et X $[(n+3)T]$ qui viennent s'écrire respectivement à la place de X $[(n-2)T]$ et de X $[(n-3)T]$. Ensuite recommence le cycle décrit ci-dessus.

Il est à remarquer que le compteur $CT_2$ d'adressage des valeurs discrètes retardées de $M_1$ et $M_2$ est de modulo P', que le compteur $CT_3$ est de modulo

$$\frac{P'}{2} + 1,$$

et que l'adresse de la première valeur discrète retardée lue dans chaque mémoire au cours d'un cycle de lecture-pondération est toujours inférieure de deux unités à l'adresse de la première valeur discrète retardée lue dans ces mêmes mémoires au cours du cycle précédent de lecture-pondération.

On remarquera également que, tout comme dans le cas général décrit ci-dessus, le réseau extrapolateur peut effectuer le traitement en temps partagé sur I canaux, par exemple $I = 32$.

A titre d'exemple on a pu réaliser un filtre extrapolateur d'ordre 55 sur 32 voies, à une fréquence d'échantillonnage de 16 kHz présentant un temps de traitement d'environ $3,6\,\mu s$ avec 0,1 dB d'affaiblissement dans la bande passante et au moins 70 dB d'affaiblissement hors de cette bande.

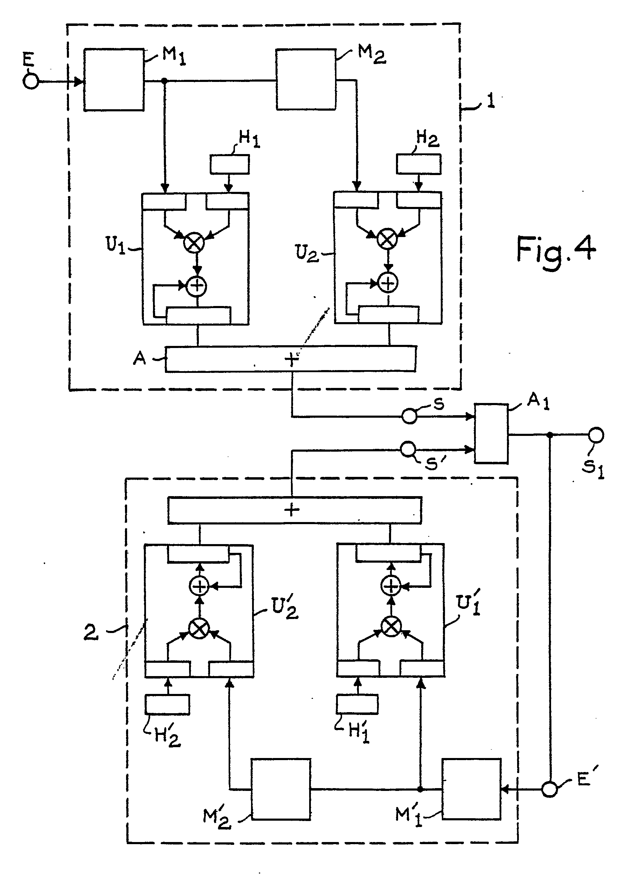

On a schématiquement représenté sur la figure 4 l'application du filtre transversal de l'invention à la réalisation d'un filtre récursif.

Dans les rectangles 1 et 2 on a représenté à chaque fois, de façon simplifiée, en omettant tous les compteurs, un filtre non recursif tel que celui de la figure 2 avec $K = 2$, les entrées et sorties des filtres des rectangles 1 et 2 étant respectivement référencées E, E' et S, S'.

L'entrée E constitue l'entrée du filtre récursif. Les sorties S et S' sont reliées à un additionneur $A_1$ dont la sortie est reliée à la fois à une borne de sortie $S_1$ et à l'entrée E' du filtre représenté dans le rectangle 2. On obtient ainsi un filtre récursif constitué de deux filtres transversaux fonctionnant chacun de la façon décrite ci-dessus, le filtre récursif pris dans son ensemble, entre la borne d'entrée E et la borne de sortie $S_1$, fonctionnant de façon connue en soi et non expliquée plus en détail.

En conclusion, le procédé de la présente invention permettant d'effectuer le déplacement des valeurs discrètes retardées par adressage relatif et simultané de chacune des mémoires, le temps nécessaire au déplacement fictif des valeurs discrètes retardées est donc négligeable.

Grâce à la décomposition du filtre en K cellules élémentaires contenant P valeurs chacune, le temps nécessaire à la synthèse de l'échantillon de sortie du filtre complet est à peine supérieur au temps nécessaire à la synthèse de l'échantillon de sortie d'une cellule élémentaire. On peut donc faire fonctionner un filtre numérique d'ordre très élevé (par exemple 256) en temps partagé sur plusieurs canaux (par exemple 32) avec des fréquences d'échantillonnage de 8 ou 16 kHz par canal par exemple. En outre, le filtre est simple à réaliser et d'encombrement réduit.

**Revendications**

1. Procédé de traitement des échantillons successifs de signaux numériques en vue de leur filtrage en particulier de signaux se présentant sur plusieurs canaux de transmission multiplexés dans le temps, caractérisé par le fait que l'on envoie à chaque intervalle d'échantillonnage, et pour chaque canal, l'échantillon correspondant dans une mémoire vive en l'inscrivant à la place de l'échantillon le plus ancien, que l'on lit successivement dans cette mémoire tous les échantillons du même canal en commençant par celui venant d'être écrit et en progressant dans l'ordre croissant d'ancienneté jusqu'à l'échantillon devenu le plus ancien, en envoyant à une unité arithmétique les différents échantillons ainsi lus pour les y pondérer de façon appropriée et que l'on fait la somme des échantillons ainsi pondérés.

2. Procédé selon la revendication 1, pour lequel on utilise plusieurs mémoires vives, caractérisé par le fait que l'on inscrit dans une première de ces mémoires un échantillon incident à la place de l'échantillon le plus ancien, que l'on lit simultanément toutes les mémoires dans l'ordre croissant d'ancienneté en commençant par l'échantillon venant d'être écrit, en envoyant de chaque mémoire à une unité arithmétique correspondante pour pondération et sommation les échantillons ainsi lus, que l'on fait la somme des résultats fournis par les différentes unités arithmétiques, et que l'on transfère de chaque mémoire vers la mémoire suivant l'échantillon devenu le plus ancien en commençant par l'avant-dernière mémoire, les mémoires étant disposées dans l'ordre croissant d'ancienneté de leur contenu.

3. Procédé selon l'une quelconque des revendications 1 ou 2, et appliqué à un réseau extrapolateur, caractérisé par le fait qu'après la lecture de l'échantillon le plus récent on avance à chaque fois de deux échantillons sauf pour la dernière lecture pour laquelle on n'avance que d'un seul échantillon, et que l'adresse de la première valeur discrète retardée lue dans la (ou dans chaque) mémoire au cours d'un cycle lecture-pondération est toujours inférieure de deux unités à l'adresse de la première valeur discrète retardée lue dans cette (ou dans ces) mémoire(s) au cours du cycle précédent de lecture-pondération.

4. Procédé selon la revendication 3, pour lequel on utilise deux ou plusieurs mémoires, caractérisé par le fait qu'au cours de la phase de transfert entre mémoires on transfère à chaque fois deux valeurs discrètes retardées.

5. Filtre numérique d'ordre M pour la mise en oeuvre du procédé selon l'une quelconque des revendications 1 ou 2, en particulier pour le traitement en temps partagé de signaux numériques se présentant sur I canaux, caractérisé par le fait qu'il comprend:

— K cellules de traitement ($C_1$ à $C_K$), K étant un nombre entier supérieur ou égal à 1, ces K cellules comportant chacune: une mémoire vive ($M_1$ à $M_K$) organisée selon I pages correspondant chacune à un canal et pouvant stocker chacune au moins P mots de $q$ éléments binaires, avec $M = KP - 1$, cette mémoire étant destinée au stockage des valeurs discrètes retardées; une mémoire morte ($H_1$ à $H_K$) ayant une capacité de P mots au moins de $r$ éléments binaires chacun pour le stockage des coefficients de pondération des différentes valeurs discrètes retardées; et une unité arithmétique ($U_1$ à $U_K$);

— un premier compteur modulo I ($CT_1$), commun aux K cellules, pour l'adressage desdites I pages;

— un second compteur modulo P ($CT_2$), commun aux K cellules, pour adresser les mémoires vives en vue d'effectuer les opérations d'écriture, de lecture et le transfert desdites valeurs discrètes retardées, et

— un troisième compteur modulo P ($CT_3$), commun aux K cellules, pour l'adressage des coefficients de pondération correspondant à l'opération à effectuer.

6. Filtre numérique selon la revendication 5, caractérisé par le fait qu'il comporte également un dispositif additionneur (A) commun aux K cellules pour effectuer la somme des différents résultats partiels produits par chaque unité arithmétique.

7. Filtre numérique d'ordre $M' = 2P' - 1$, P' étant pair, pour la mise en oeuvre du procédé selon l'une des revendications 3 ou 4, caractérisé par le fait qu'il comporte à l'entrée un dispositif tampon (T), que ledit second compteur est de modulo P', et que ledit troisième compteur est de modulo

$$\frac{P'}{2} + 1.$$

## Patentansprüche

1. Verfahren zur Verarbeitung von aufeinanderfolgenden digitalen Signaltastwerten zu ihrer Filterung, insbesondere von Signalen, die sich in mehreren zeitmultiplexierten Übertragungskanälen befinden, dadurch gekennzeichnet, daß in jedem Tastintervall und für jeden Kanal der entsprechende Tastwert in einen Aktivspeicher eingegeben wird, in dem er anstelle des ältesten Tastwerts eingeschrieben wird, daß man aus diesem Speicher nacheinander alle Tastwerte desselben Kanals ausliest, beginnend mit dem gerade eingegebenen Tastwert und weiter in Richtung früher eingegebener Tastwerte bis zu dem Tastwert, der der älteste geworden ist, wobei die so ausgelesenen Testwerte an eine Recheneinheit zur geeigneten Gewichtung weitergegeben werden, und daß die Summe der so gewichteten Tastwerte gebildet wird.

2. Verfahren nach Anspruch 1 unter Verwendung mehrerer Aktivspeicher, dadurch gekennzeichnet, daß man in einen ersten dieser Speicher den aktuellen Tastwert anstelle des ältesten Tastwerts einschreibt, daß gleichzeitig aus allen Speichern in der Reihenfolge zunehmenden Alters und beginnend mit dem gerade eingeschriebenen Tastwert ausgelesen wird und die so ausgelesenen Tastwerte jedes Speichers an eine entsprechende Recheneinheit zur Gewichtung und Summenbildung weitergegeben werden, daß die Summe der von den einzelnen Recheneinheiten gebildeten Ergebnissen errechnet wird und daß von jedem Speicher zum nächsten beginnend mit dem vorletzten Speicher der nunmehr älteste Tastwert übertragen wird, wobei die Speicher in der Reihenfolge zunehmenden Alters ihres Inhalts angeordnet sind.

3. Verfahren nach einem beliebigen der Ansprüche 1 oder 2, und in Anwendung an ein Extrapolationsnetz, dadurch gekennzeichnet, daß nach dem Auslesen des jüngsten Tastwerts jedesmal um zwei Tastwerte weitergeschritten wird, mit Ausnahme des letzten Auslesens, bei dem man nur um einen Tastwert weiterschreitet, und daß die Adresse des ersten verzögerten diskreten Wertes, der aus dem Speicher (oder aus jedem Speicher) im Verlauf eines Lese-Gewichtungs-Zyklus ausgelesen wird, stets um zwei Einheiten geringer ist als die Adresse des ersten verzögerten diskreten Werts, der aus dem (oder jedem) Speicher im Verlaufe des vorhergehenden Lese-Gewichtungs-Zyklus ausgelesen worden ist.

4. Verfahren nach Anspruch 3, bei dem zwei oder mehr Speicher Verwendung finden, dadurch gekennzeichnet, daß im Verlauf der Übertragungsphase zwischen den Speichern jedesmal zwei verzögerte diskrete Werte übertragen werden.

5. Digitales Filter der Ordnung M für die Durchführung des Verfahrens nach einem beliebigen der Ansprüche 1 oder 2, insbesondere für die Verarbeitung von digitalen Signalen im Zeitmultiplex, die auf I Kanälen vorliegen, dadurch gekennzeichnet, daß es aufweist:

— K Verarbeitungszellen ($C_1$ bis $C_K$), wobei K eine ganze Zahl größer oder gleich 1 ist und die K Zellen je einen Aktivspeicher ($M_1$ bis $M_K$), der gemäß I Seiten organisiert ist, entsprechend je einem Kanal und geeignet zur Speicherung von je mindestens P Wörtern mit q Binärelementen, wobei $M = KP - 1$ und wobei der Speicher zur Speicherung der verzögerten diskreten Werte bestimmt ist, je einen Festwertspeicher ($H_1$ bis $H_K$) mit einer Kapazität von mindestens P Wörtern zu r Binärelementen für die Speicherung der Wichtungskoeffizienten der verschiedenen verzögerten diskreten Werte und je eine Recheneinheit ($U_1$ bis $U_K$) aufweist;

— einen ersten Zähler modulo I ($CT_1$), der allen K Zellen gemeinsam ist und der Adressierung der I Seiten dient;

— einen zweiten Zähler modulo P ($CT_2$), der allen K Zellen gemeinsam ist und der Adressierung der Aktivspeicher für die Durchführung der Schreib-, Lese- und Übertragungsoperationen der verzögerten diskreten Werte dient, und

— einen dritten Zähler modulo P ($CT_3$) enthält, der allen K Zellen gemeinsam ist und der Adressierung der der durchzuführenden Operation entsprechenden Wichtungskoeffizienten dient.

6. Digitales Filter nach Anspruch 5, dadurch gekennzeichnet, daß es außerdem einen Addierschaltkreis (A) enthält, der allen K Zellen gemeinsam ist und der Summenbildung aus den verschiedenen Teilresultaten dient, die von jeder Recheneinheit gebildet worden sind.

7. Digitalfilter nach Ordnung $M' = 2P' - 1$, wobei P' eine gerade Zahl ist, zur Durchführung des Verfahrens nach einem der Ansprüche 3 oder 4, dadurch gekennzeichnet, daß es eingangsseitig eine Pufferanordnung (T) aufweist, daß der zweite Zähler ein Zähler modulo P' ist und daß der dritte Zähler modulo

$$\frac{P'}{2} + 1$$

zählt.

## Claims

1. A method for processing successive digital signal samples for being filtered, especially signals which are furnished on several time division multiplex transmission channels, characterized in that at each sampling time slot and for each channel the corresponding sample is sent to an active memory and is inscribed in the place of the oldest sample, that all the samples of one channel are read successively from said memory, starting with the sample which has just been inscribed and progressing backwardly in the sample age up to the sample which has become the oldest sample, that these different samples are sent after reading to an arithmetic unit where they are weighted in the appropriate manner, and that these weighted samples are summed up.

2. A method according to claim 1, in which several active memories are used, characterized in that an incident sample is inscribed into the first one of said memories in the place of the oldest sample, that samples are read simultaneously from all the memories in the order of increasing age and starting with the sample which has just been inscribed, the samples which have thus been read being sent from each memory to a corresponding arithmetic unit for weighting and summing up reasons, that the sum is established out of the results furnished by the different arithmetic units, and that the sample which has become the oldest one is transferred from each memory to the next one, beginning with the next to last memory, the memories being arranged according to the growing age of their contents.

3. A method according to any one of claims 1 or 2, and applied to an extrapolator network, characterized in that when the most recent sample has been read, one advances at each time by two samples except for the last reading operation in which one advances by only one sample, and that the address of the first delayed discrete value which has been read out of the memory (or out of each memory) during a reading-weighting cycle is always lower by two units with respect to the address of the first delayed discrete value which is read out of that memory or memories during the preceding reading-weighting cycle.

4. A method according to claim 3, in which two or more memories are employed, characterized in that at any time two delayed discrete values are transferred between the memories during the transfer phase.

5. Digital filter of the order M for the implementation of the method according to any one of the claims 1 or 2, especially for the processing in the time division mode of digital signals which arrive on I channels, characterized in that it comprises

— K processing cells ($C_1$ to $C_K$), K being an integer which is at least 1, the K cells comprising each: an active memory ($M_1$ to $M_K$), organized according to I pages which correspond each to a channel and which can each store at least P words of q bits, with $M = KP - 1$, this memory being intended to store the delayed discrete values; a ROM ($H_1$ to $H_K$) having a capacity of at least P words of r bits for storing the weighting coefficients of the particular delayed discrete values; and an arithmetic unit ($U_1$ to $U_K$);

— a first counter modulo I ($CT_1$) which is common to the K cells and which is used to address the I pages;

— a second counter modulo P ($CT_2$) which is common to the K cells and which is used to address the active memories during the writing, reading and transfer operations of said delayed discrete values, and

    — a third counter modulo P $(CT_3)$ which is common to the K cells and which is used to address the weighting coefficients corresponding to the operation which should be performed.

6. Digital filter according to claim 5, characterized in that it further comprises an adding device (A) which is common to the K cells and which is used to build up the sum of the different partial results which have been produced by each arithmetic unit.

7. Digital filter of the order $M' = 2P' - 1$, P' being an even number, for the implementation of the method according to one of the claims 3 or 4, characterized in that it comprises at the input a buffer device (T), that the second counter is a counter modulo P' and that the third counter is a counter modulo

$$\frac{P'}{2} + 1.$$

Fig.1

Fig.2

0014151

Fig.3

Fig.4